# EUROPEAN PATENT SPECIFICATION

(11) **EP 3 190 607 B1**
(45) Date of publication and mention of the grant of the patent: **18.12.2019**
(21) Application number: 15831329.6
(22) Date of filing: 29.07.2015
(51) Int. Cl.: B08B 3/08, B08B 3/14, H01L 21/67, H01L 21/205, H01L 21/02

(54) **DEVICE AND METHOD FOR PROCESSING SEMICONDUCTOR WAFER SURFACE UTILIZING FLUID CONTAINING OZONE**
VORRICHTUNG UND VERFAHREN ZUR VERARBEITUNG EINER HALBLEITERWAFEROBERFLÄCHE MIT OZONHALTIGER FLÜSSIGKEIT
DISPOSITIF ET PROCÉDÉ POUR TRAITER UNE SURFACE DE TRANCHE DE SEMI-CONDUCTEUR À L'AIDE D'UN FLUIDE CONTENANT DE L'OZONE

(30) Priority: 14.08.2014 CN 201410401635
(43) Date of publication of application: 12.07.2017
(73) Proprietor: Huaying Research Co., Ltd, Wuxi, Jiangsu 214135 (CN)
(72) Inventor: WEN, Sophia, Wuxi Jiangsu 214135 (CN); ZHANG, Nitao, Wuxi Jiangsu 214135 (CN)
(74) Representative: Sun, Yiming
(86) International application number: PCT/CN2015/085371
(87) International publication number: WO 2016/023414

(56) References cited:
- EP-A2- 0 548 596
- CN-A- 1 480 994
- CN-A- 1 762 042
- CN-A- 101 752 215
- US-A1- 2002 007 790
- US-A1- 2003 205 240
- US-A1- 2004 154 641
- US-A1- 2006 151 007

## Description

### FIELD OF THE INVENTION

The present invention relates to a fabrication process of semiconductor materials and in particular to an apparatus and method for processing a semiconductor wafer surface with fluids containing ozone.

In particular the invention relates to an apparatus for processing a semiconductor wafer surface with fluids containing ozone, comprising: an ozone generator, a solvent flask, a gas-liquid mixing device, a closed chamber or containing the wafer to be processed, and a gas-liquid delivery system and a gas-liquid discharge system; wherein the ozone generator and the solvent flask are connected with corresponding inlets of the gas-liquid mixing device, respectively, and outlets of the gas-liquid mixing device are connected with at least one inlet of the closed chamber, as well as to a usage method for such apparatus.

### BACKGROUND OF THE INVENTION

EP 0 548 596 A2 discloses an apparatus of the generic type defined above, as well as a usage method for such apparatus.

In semiconductor fabrication processes, for purposes of preparing an ultra-clean semiconductor wafer surface, a wafer surface typically undergoes a cleaning process with a wide variety of chemical liquids or gases according to different process requirements. So far, most of the cleaning processes have still been based on traditional RCA cleaning recipes (referred to as "SC1 and SC2 cleaning solutions") and the cleaning solutions formed of a mixture of sulfuric acid and hydrogen peroxide (referred to as "SPM"). The mixed cleaning solution of sulfuric acid and hydrogen peroxide is employed to remove organic contaminants, photoresists on a wafer surface and generate a thin oxide layer on the wafer surface. The No. 1 cleaning solution (SC1) formed of a mixture of ammonium hydroxide and hydrogen peroxide is used to remove particles, a portion of organic compounds as well as a portion of metals on the wafer surface. The No. 2 cleaning solution (SC2) formed of a mixture of hydrochloric acid and hydrogen peroxide is used to remove metal ions on the wafer surface. RCA cleaning recipes include hydrogen peroxide used in oxidation reaction; the SPM cleaning process needs to consume large quantities of concentrated sulfuric acid, followed by large quantities of ultra-pure water for rinsing, which is environmentally unsound and poses a potential threat to the safety and health of operators. Therefore, it is essential to look for a safe, economical and environmentally friendly alternative cleaning process and recipe whose cleaning effect is comparable to or better than the SPM.

As is known to all, ozone gas possesses extremely strong oxidizability, an oxidation/reduction chemical reaction possibly occurs with a plurality of substances, such as organics and silicon, etc. and the ozone gas is reduced to oxygen after the oxidation/reduction reaction, which is harmless to humans and environment. So ozone gas or an ozone aqueous solution formed of a mixture of ozone gas and water is a safe, economical and environmentally friendly cleaning process and recipe. The ozone aqueous solution has always been studied for removal of organic contaminants and photoresists, but has not been widely applied for the main reason that a concentration of the ozone in chemical reactions is difficult to ensure and control, which cannot meet the processing requirements.

Normally, the dissolved concentration of ozone gas in water follows Henry's law that a concentration of ozone in liquid phase is proportional to a partial pressure of ozone in gas phase. It is necessary to increase the partial pressure of ozone in gas phase for obtaining an ozone aqueous solution in a high concentration. Existing cleaning equipments based on immersion and spray techniques form an ozone aqueous solution in a higher concentration by premixing ozone and water and next transferring the prepared ozone solution in a higher concentration into a soaking reservoir or sprayed onto the wafer surface for surface treatment. Once the ozone aqueous solution is transferred into the soaking reservoir or sprayed onto the wafer surface, the ozone in the water will be immediately escaped from an interface of liquid and gas to the gas phase since it is difficult to maintain a high level of concentration of ozone in the gas phase of the interface of liquid and gas, that is, the partial pressure of ozone in the gas phase is lower, and since the ozone aqueous solution is in a relatively open environment during treatment. Therefore, the ozone concentration in the ozone aqueous solution will be reduced rapidly and continuously, thereby influencing the processing effect.

### SUMMARY OF THE INVENTION

Aiming at the above problems, the present invention provides an apparatus and method for processing a semiconductor wafer surface with fluids containing ozone. The apparatus and method not only can improve a processing effect of an ozone-containing fluid on a semiconductor wafer surface, but also can reduce consumptions of the used gases and fluids and decrease emissions.

The technical solution of the apparatus in the present invention is as follows: an apparatus for processing a semiconductor wafer surface with fluids containing ozone comprises: an ozone generator, a solvent flask, a gas-liquid mixing device, a closed chamber for containing the wafer to be processed, and a gas-liquid delivery system and a gas-liquid discharge system; wherein the ozone generator and the solvent flask are connected with corresponding inlets of the gas-liquid mixing device, respectively, and outlets of the gas-liquid mixing device are connected with at least one inlet of the closed chamber. In addition, a gas-liquid separation device or another ozone generator is provided for ensuring a concentration of ozone in solution by transferring gas-liquid mixed fluids containing ozone via the gas-liquid separation device or solutions containing ozone and ozone gas after generation by the another ozone generator into the closed chamber and by increasing a partial pressure of ozone in gas phase.

Furthermore, a gas-liquid separation device is disposed between the gas-liquid mixing device and the closed chamber; one outlet of the gas-liquid mixing device is connected with one inlet of the gas-liquid separation device; at least one outlet of the gas-liquid separation device is connected with at least one inlet of the closed chamber.

Furthermore, a switching valve is disposed between the gas-liquid mixing device, the closed chamber and the gas-liquid separation device, and three outlets of the switching valve are connected with the gas-liquid mixing device, the closed chamber and the gas-liquid separation device, respectively; and at least one outlet of the gas-liquid separation device is connected with at least one inlet of the gas-liquid mixing device.

Furthermore, the apparatus further comprises: another gas-liquid mixing device, another ozone generator, another solvent flask and another switching valve; wherein the another ozone generator and the another solvent flask are connected with corresponding inlets of the another gas-liquid mixing device, respectively; four outlets of one of the switching valves are connected with the two gas-liquid mixing devices, the closed chamber and the another switching valve, respectively; the other two outlets among the three outlets of the another switching valve are connected with the two gas-liquid separation devices, respectively.

Furthermore, the apparatus further comprises: another gas-liquid separation device and another switching valve; four outlets of one of the switching valves are connected with the gas-liquid mixing device, the closed chamber and the two gas-liquid separation devices, respectively; three outlets of the another switching valve are connected with the gas-liquid mixing device and the two gas-liquid separation devices, respectively.

Furthermore, the apparatus further comprises: another ozone generator; wherein at least one outlet of the another ozone generator is connected with at least one inlet of the closed chamber.

Furthermore, the closed chamber is in a structure of micro processing chamber that comprises an upper chamber portion and a lower chamber portion associated with each other; the upper chamber portion and/or the lower chamber portion comprises at least one inlet configured to allow treatment fluids to be transferred into the micro processing chamber and at least one outlet configured to discharge the treatment fluids out of the micro processing chamber.

The technical solution of the method in the present invention is as follows: a usage method for being implemented by the apparatus according to the invention, the method comprising: transferring an ozone gas generated by the ozone generator and a solvent in the solvent flask into the gas-liquid mixing device of said apparatus, respectively; mixing the ozone gas and the solvent to obtain mixed fluids containing the ozone gas or solutions containing ozone; and transferring the mixed fluids or solutions into the closed chamber of said apparatus after having obtained sand mixed fluids or solutions.

Furthermore, a gas-liquid separation device is disposed between the gas-liquid mixing device and the closed chamber; the mixed fluids obtained in the gas-liquid mixing device are transferred into the gas-liquid separation device; and the solutions containing ozone are transferred into the closed chamber -via the gas-liquid separation.

Furthermore, a switching valve is disposed between the gas-liquid mixing device, the closed chamber and the gas-liquid separation device; the mixed fluids obtained in the gas-liquid mixing device are transferred into the gas-liquid separation device by switching the switching valve, and then transferred into the gas-liquid mixing device via the gas-liquid separation so as to form mixed fluids in a higher concentration, and the mixed fluids are transferred into the closed chamber through different channels by switching the switching valve until a desired concentration is reached, wherein one channel leads into the closed chamber directly, and the other channel leads into the gas-liquid separation device and then the solutions containing ozone are transferred into the closed chamber via the gas-liquid separation.

Furthermore, the apparatus further comprises: another gas-liquid mixing device, another ozone generator, another solvent flask and another switching valve; the mixed fluids in a higher concentration obtained from multiple gas-liquid mixings in one of the gas-liquid mixing devices are transferred into the chamber by switching one of the switching valves, and meanwhile the mixed fluids in the higher concentration are obtained from multiple gas-liquid mixings of the mixed fluids occurred in the another gas-liquid mixing device; after the mixed fluids obtained from one of the gas-liquid mixing devices are exhausted, the mixed fluids in the higher concentration having been generated in the another gas-liquid mixing device are transferred into the closed chamber by switching one of the switching valves and meanwhile multiple gas-liquid mixings of the mixed fluids occur in one of the gas-liquid mixing devices once again.

Furthermore, the apparatus further comprises: another gas-liquid separation device and another switching valve; solutions containing ozone in a higher concentration obtained in one of the gas-liquid separation devices are transferred into the closed chamber by switching one of the switching valves and meanwhile multiple gas-liquid mixings of the mixed fluids occur in the gas-liquid mixing devices and the solutions containing ozone in the higher concentration are obtained in the another gas-liquid separation device; after the solutions containing ozone obtained in one of the gas-liquid separation devices are exhausted, the solutions containing ozone in the higher concentration obtained in the another gas-liquid separation device are transferred into the closed chamber by switching one of the switching valves and meanwhile the multiple gas-liquid mixings of the mixed fluids occur in the gas-liquid mixing device once again and the solutions containing ozone in the higher concentration are obtained in one of the gas-liquid separation devices.

Furthermore, the apparatus further comprises: another ozone generator; the mixed fluids containing ozone or the solutions containing ozone are transferred into the closed chamber, while the ozone gas generated from the another ozone generator is transferred into the closed chamber.

The method for forming a passivation layer on a semiconductor substrate surface using ozone that is generated by the apparatus of the invention includes the following three technical solutions:
The first technical solution is as follows:
A method for forming a semiconductor substrate surface passivation layer, which is used to passivate the semiconductor substrate fresh out of the furnace, comprising:
(a) placing the semiconductor substrate out of the furnace in a micro processing chamber;
(b) closing the chamber;
(c) transferring ozone gas into the chamber for 2-10 min; and
(d) opening the chamber and removing the semiconductor substrate.

A further technical solution is as follows:
A method for forming a semiconductor substrate surface passivation layer, which is used to passivate the semiconductor substrate having a natural oxide layer, comprising:
(a) placing a semiconductor substrate in a micro processing chamber;
(b) closing the chamber;
(c) transferring an HF-containing gas or liquid into the chamber;
(d) transferring ultrapure water into the chamber;
(e) drying the chamber;
(f) transferring ozone gas into the chamber for 2-10 min;
(g) opening the chamber and removing the semiconductor substrate.

Another technical solution is as follows:
A method for forming a semiconductor substrate surface passivation layer, which is used to passivate the semiconductor substrate having a natural oxide layer, comprising:
(a) placing a semiconductor substrate in a micro processing chamber;
(b) closing the chamber;
(c) transferring an HF-containing gas or liquid into the chamber;
(d) transferring the ozonated water into the chamber for 2-10 min, the ozonated water is obtained by mixing ozone and water using the gas-liquid mixing device;
(e) drying the chamber;
(f) opening the chamber and removing the semiconductor substrate.

The technical effect of the present invention is to ensure a concentration of ozone in solution, and in turn to improve a processing effect of an ozone-containing fluid on a wafer surface positioned inside the closed chamber by immediately transferring gas-liquid mixed fluids that contain ozone or solutions containing ozone and ozone gas after generation into one closed chamber and by increasing a partial pressure of ozone in gas phase, shortening a duration of ozone from being generated to being applied.

### BRIEF DESCRIPTION OF THE DRAWINGS

Fig. 1 is a structure diagram of the apparatus in the first example of the present invention;
Fig. 2 is a structure diagram of the apparatus in the second example of the present invention;
Fig. 3 is a structure diagram of the apparatus in the third example of the present invention;
Fig. 4 is a structure diagram of the apparatus in the fourth example of the present invention;
Fig. 5 is a structure diagram of the apparatus in the fifth example of the present invention;
Fig. 6 is a structure diagram of the apparatus in the sixth example of the present invention;
Fig. 7 is a structure diagram of the apparatus in the seventh example of the present invention;
Fig. 8 is a structure diagram of the apparatus in the eighth example of the present invention;
Fig. 9 is a structure diagram of the apparatus in the ninth example of the present invention;
Fig. 10 is a structure diagram of the apparatus in the tenth example of the present invention;
Fig. 11 is a structure diagram of the apparatus in an embodiment of the present invention;
Fig. 12 is a diagram of position where resistivity and film thickness of semiconductor substrate passivation layer are tested.

### DETAILED DESCRIPTION OF THE INVENTION

To make the above objects, features and advantages of the present invention be more obvious and easy to understand, the present invention will be further described in detail below in conjunction with the particular embodiments.

The present invention provides an apparatus for processing a semiconductor wafer surface with fluids containing ozone, which not only can implement a technological treatment of a semiconductor wafer surface, but also can be used for the similar surface chemical treatment of solids.

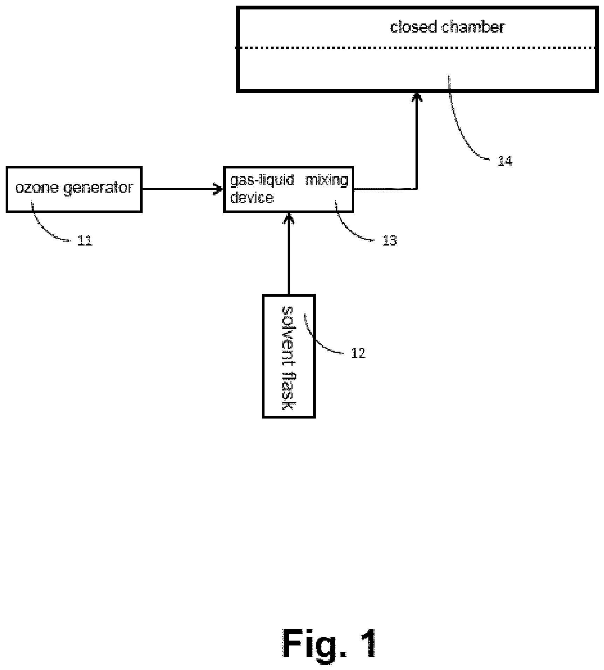

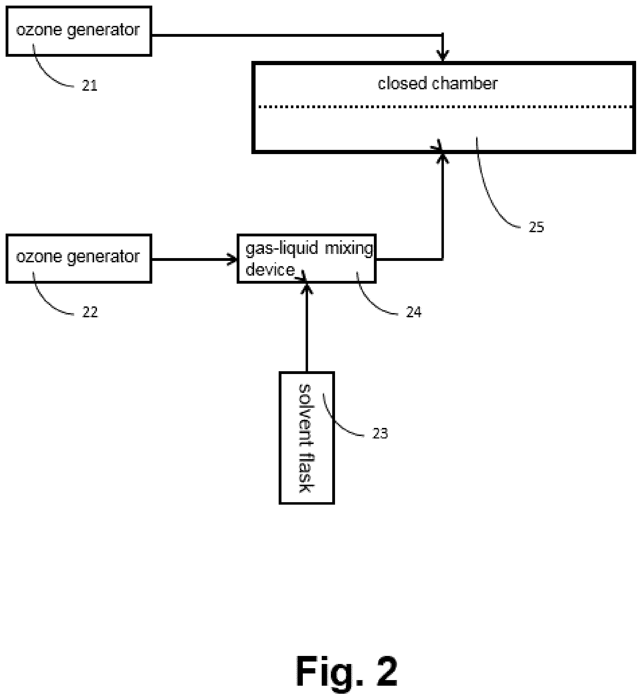

Fig.1 is a structure diagram of the apparatus in the first example of the present invention, comprising: an ozone generator 11, a solvent flask 12, a gas-liquid mixing device 13, a closed chamber 14, as well as a gas-liquid delivery system and a gas-liquid discharge system (not shown). The ozone generator 11 and the solvent flask 12 are connected with the corresponding inlets of the gas-liquid mixing device 13, respectively, and outlets of the gas-liquid mixing device 13 are connected with at least one inlet of the closed chamber 14. In the case that the apparatus is employed to process the semiconductor wafer, transferring the ozone gas generated by the ozone generator 11 and the solvent in the solvent flask 12 into the gas-liquid mixing device 13, respectively, for mixing the ozone gas and solvent to obtain mixed fluids of ozone gas and solvent containing ozone; and transferring the mixed fluids into the closed chamber 14 immediately, an oxidation/reduction chemical reaction occurs with wafer surfaces inside the closed chamber 14. Not only ozone remaining in the gas phase of gas-liquid mixing fluids and chemical substances produced when ozone is mixed with the solvent, but also ozone remaining in the liquid phase of gas-liquid mixing fluids and chemical substances produced when ozone is mixed with the solvent, can chemically react with the wafer surface. On the one hand, since the chemical reaction is in a sealed environment of the closed chamber 14, the ozone in gas phase of the above-mentioned mixed fluids remains in the sealed environment, increases the ozone content in the chamber 14, relatively increases the partial pressure of ozone in gas phase, suppresses ozone dissolved in the solvent escaping from the liquid level to the gas phase, which ensures the ozone concentration in the solutions, thereby meeting the processing requirements in a preferable way; on the other hand, since ozone is easily decomposed into oxygen and a half-life period is short and generally remains only 20-120 minutes, and therefore a duration of ozone from being generated to being applied should be shortened as much as possible. By shortening the delivery distance from the ozone generator to the closed chamber containing the wafer for which treatments will be required, ensuring the concentration of the ozone in gas phase and in liquid phase and improving a processing effect of an ozone-containing fluid on a wafer. Furthermore, when transferring the mixed fluids into the closed chamber, improving the gas phase partial pressure of ozone inside the chamber and reducing the ozone in the solutions inside the chamber transferred from the gas-liquid mixing device escaping from the fluids by adding another ozone generator and directly delivering the generated ozone to the chamber. Fig. 2 illustrates a structure diagram of the apparatus in the second example of the present invention. Fig. 2 comprises: an ozone generator 21, an ozone generator 22, a solvent flask 23, a gas-liquid mixing device 24 and a closed chamber 25. The other components of the apparatus and the method for processing a wafer are similar to the first example of the present invention and therefore the detailed description thereof will be omitted.

One emphasis, advantage or benefit of the present invention is that: the solutions containing ozone, ozone gas or gas-liquid mixed fluids containing ozone being transferred into the closed chamber are generated online and are transferred into the closed chamber via pipelines in real time, which can inhibit decomposing the ozone to oxygen.

If the process needs to conduct a surface treatment of a semiconductor wafer using ozone solutions, a gas-liquid separation can be achieved by a gas-liquid separation device and then solutions containing ozone are transferred into the closed chamber.

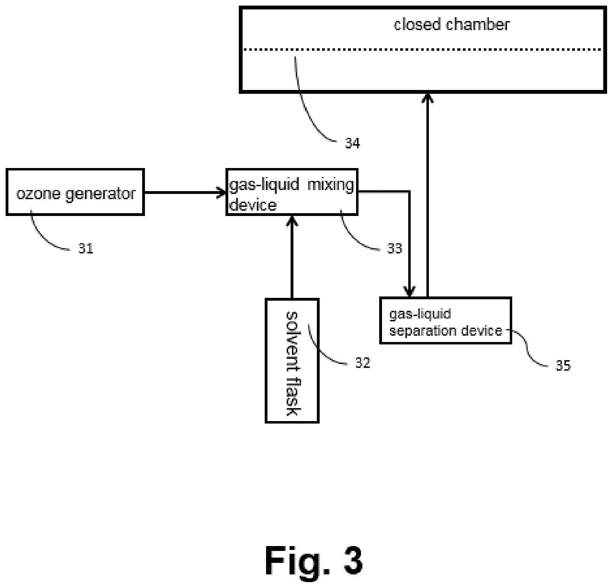

Fig. 3 illustrates a structure diagram of the apparatus in the third example of the present invention. The apparatus comprises: an ozone generator 31, a solvent flask 32, a gas-liquid mixing device 33, a closed chamber 34, a gas-liquid separation device 35, as well as a gas-liquid delivery system and a gas-liquid discharge system (not shown). The ozone generator 31 and the solvent flask 32 are connected with the corresponding inlets of the gas-liquid mixing device 33, respectively, one outlet of the gas-liquid mixing device 33 is connected with one inlet of the gas-liquid separation device 35 and at least one outlet of the gas-liquid separation device 35 is connected with at least one inlet of the closed chamber 34. In the case that the apparatus is employed to process the semiconductor wafer, transferring the ozone gas generated by the ozone generator 31 and the solvent in the solvent flask 32 into the gas-liquid mixing device 33, respectively, for mixing the ozone gas and solvent to obtain mixed fluids of ozone gas and solutions containing ozone; and next transferring the mixed fluids into the gas-liquid separation device 35 and transferring the solutions containing ozone via the gas-liquid separation into the closed chamber 34 for surface treatment of the wafer inside the closed chamber 34. The ozone gas released from the ozone solutions is detained in the closed chamber 34, so that the content of the gas phase ozone in the closed chamber 34 is higher than that of the ozone gas in the outer atmosphere, that is, increasing a partial pressure of ozone in gas phase, the ozone dissolved in the solvent is not easily escaped from the fluids, which ensures the ozone concentration in the ozone solution, thereby meeting the process requirements.

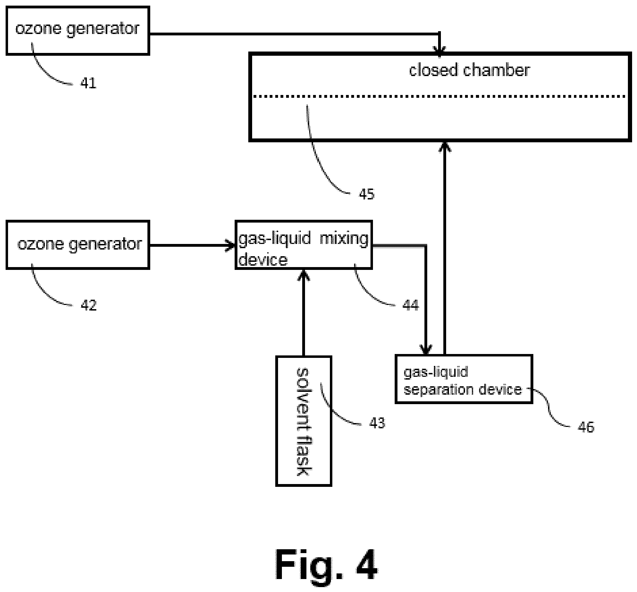

By the same token, while transferring the above-mentioned ozone solution into the closed chamber, improving the gas phase partial pressure of ozone inside the closed chamber and reducing the ozone in the solutions inside the chamber transferred from the gas-liquid mixing device escaping from the fluids by adding another ozone generator and directly delivering the generated ozone into the chamber. Fig. 4 illustrates a structure diagram of the apparatus in the fourth example of the present invention. Fig. 4 comprises: an ozone generator 41, an ozone generator 42, a solvent flask 43, a gas-liquid mixing device 44, a closed chamber 45 and a gas-liquid separation device 46. The other components of the apparatus and the method for processing a wafer are similar to the third example of the present invention and therefore the detailed description thereof will be omitted.

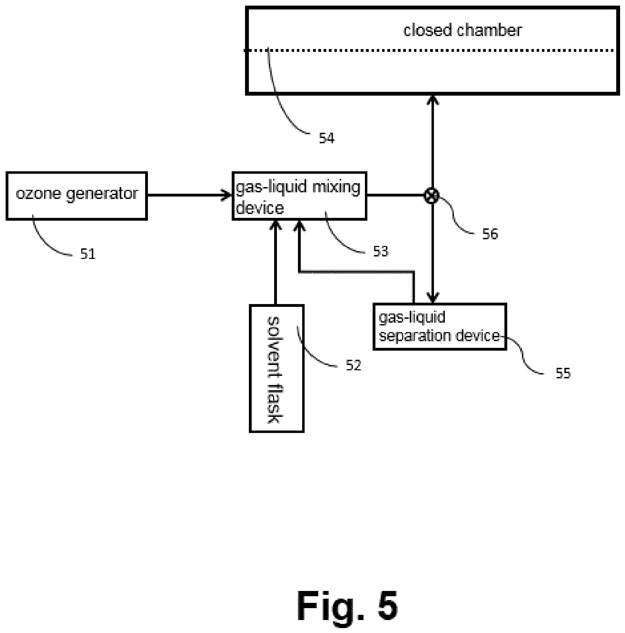

Furthermore, achieving gas-liquid mixings repeated many times by converting lines by the switching valve for forming mixed fluids containing ozone in a higher concentration and next transferring the mixed fluids or the solutions containing ozone in a higher concentration obtained from the mixed fluids via the gas-liquid separation into the closed chamber for surface treatment of wafer. Fig. 5 illustrates a structure diagram of the apparatus in the fifth example of the present invention. The apparatus comprises: an ozone generator 51, a solvent flask 52, a gas-liquid mixing device 53, a closed chamber 54, a gas-liquid separation device 55, a switching valve 56, as well as a gas-liquid delivery system and a gas-liquid discharge system (not shown). The ozone generator 51 and the solvent flask 52 are connected with the corresponding inlets of the gas-liquid mixing device 53, respectively, the three outlets of the switching valve 56 are connected with the gas-liquid mixing device 53, the closed chamber 54 and the gas-liquid separation device 55, respectively, and at least one outlet of the gas-liquid separation device 55 is connected with at least one inlet of the gas-liquid mixing device 53. In the case that the apparatus is employed to process the semiconductor wafer, transferring the ozone gas generated by the ozone generator 51 and the solvent in the solvent flask 52 to the gas-liquid mixing device 53, respectively, for mixing the ozone gas and solvent to form mixed fluids of ozone gas and solutions containing ozone; and next transferring the mixed fluids into the gas-liquid separation device 55 by switching the switching valve 56, and transferring the mixed fluids via the gas-liquid separation into the gas-liquid mixing device 53 once again so as to form mixed fluids in a higher concentration, and the mixed fluids are transferred into the closed chamber 54 through different channels by switching the switching valve 56 until a desired concentration is reached, wherein one channel directly transfers the gas-liquid mixed fluids into the closed chamber 54 for surface treatment of the wafer positioned inside the closed chamber 54, and the other channel first transfers the gas-liquid mixed fluids into the gas-liquid separation device 55 and next transfers the solutions containing ozone into the closed chamber 54 via the gas-liquid separation for surface treatment of the wafer positioned inside the closed chamber 54.

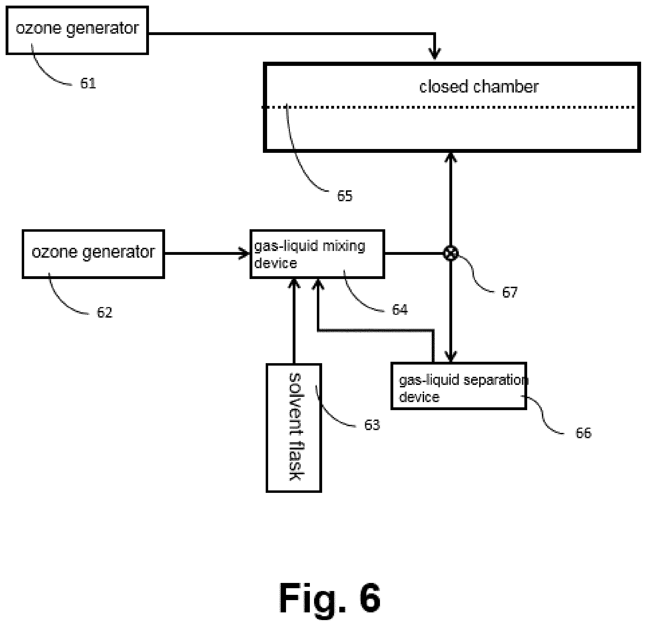

By the same token, while transferring the above-mentioned mixed fluids or ozone solutions into the closed chamber, improving the gas phase partial pressure of ozone inside the chamber and reducing the ozone in the solutions inside the chamber transferred from the gas-liquid mixing device escaping from the fluids by adding another ozone generator and directly delivering the generated ozone to the chamber. Fig.6 illustrates a structure diagram of the apparatus in the sixth example of the present invention. Fig. 6 comprises: an ozone generator 61, an ozone generator 62, a solvent flask 63, a gas-liquid mixing device 64, a closed chamber 65, a gas-liquid separation device 66 and a switching valve 67. The other components of the apparatus and the method for processing a wafer are similar to the fifth example of the present invention and therefore the detailed description thereof will be omitted.

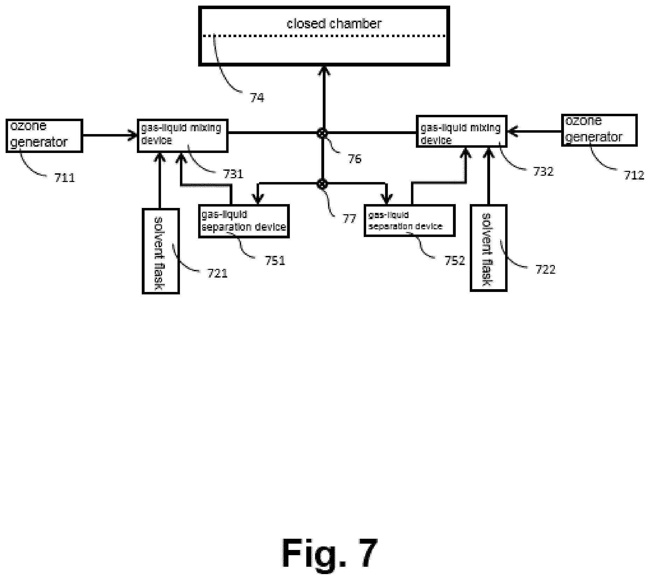

Furthermore, achieving mixed fluids in a higher concentration alternately obtained by adding another set of equipment that can produce mixed fluids containing ozone, and transferring continuously the prepared mixed fluids into the chamber for surface treatment of wafer. Fig.7 illustrates a structure diagram of the apparatus in the seventh example of the present invention. The apparatus comprises: an ozone generator 711, a solvent flask 721, a gas-liquid mixing device 731, a closed chamber 74, a gas-liquid separation device 751, a switching valve 76, a switching valve 77, an ozone generator 712, a solvent flask 722, a gas-liquid mixing device 732, a gas-liquid separation device 752, as well as a gas-liquid delivery system and a gas-liquid discharge system (not shown). The ozone generator 711 and the solvent flask 721 are connected with the corresponding inlets of the gas-liquid mixing device 731, respectively; the ozone generator 712 and the solvent flask 722 are connected with the corresponding inlets of the gas-liquid mixing device 732, respectively; the four outlets of the switching valve 76 are connected with the gas-liquid mixing device 731, the closed chamber 74, the gas-liquid mixing devices 732 and the switching valve 77, respectively; the three outlets of the switching valve 77 are connected with the switching valve 76, the gas-liquid separation device 751 and the gas-liquid separation device 752, respectively. In the case that the apparatus is employed to process the semiconductor wafer, transferring the ozone gas generated by the ozone generator 711 and the solvent in the solvent flask 721 to the gas-liquid mixing device 731, respectively, for mixing the ozone gas and solvent to obtain mixed fluids of ozone gas and solutions containing ozone; and next transferring the mixed fluids into the gas-liquid separation device 751 by switching the switching valve 76 and switching valve 77; transferring the mixed fluids into the gas-liquid mixing device 731 once again via the gas-liquid separation so as to form mixed fluids in a higher concentration, and the mixed fluids are transferred into the closed chamber 74 by switching the switching valve 76 until a desired concentration is reached, and a surface treatment is conducted for the wafer positioned inside the closed chamber 74; and meanwhile, transferring the ozone gas generated by the ozone generator 712 and the solvent in the solvent flask 722 to the gas-liquid mixing device 732, respectively, for mixing the ozone gas and solvent to obtain mixed fluids of ozone gas and solutions containing ozone; and next transferring the mixed fluids into the gas-liquid separation device 752 by switching the switching valves 76 and 77; and transferring the mixed fluids into the gas-liquid mixing device 752 once again via the gas-liquid separation to form the mixed fluids in a higher concentration following mixings repeated many times. As the mixed fluids obtained in the gas-liquid mixing device 731 are exhausted, transferring the mixed fluids obtained in the gas-liquid mixing device 732 by switching the switching valve 76 into the closed chamber 74 for surface treatment of wafer positioned inside the chamber 74; meanwhile, the mixed fluids are retrieved in the gas-liquid mixing device 731 and are circulated between the gas-liquid mixing device 731 and the gas-liquid separation device 751 so as to obtain the mixed fluids in a higher concentration. The gas phase ozone in the mixed fluids produced after repeated gas-liquid mixing is retained within the closed chamber 74, so that the content of the gas phase ozone in the closed chamber 74 is higher than the content of the ozone gas in the outer atmosphere, that is, increasing a partial pressure of ozone in gas phase, the ozone dissolved in the solvent is not easily escaped from the fluids, which ensures the ozone concentration in the ozone solution, thereby meeting the process requirements. It is to be remarked further that the above process consists of two sets of equipments that can produce the mixed fluids containing ozone for obtaining mixed fluids in a higher concentration, which can implement that the mixed fluids containing ozone are circulated between one gas-liquid mixing device and one gas-liquid separation device so as to generate the mixed fluids in a higher concentration; meanwhile, transferring the mixed fluids in the higher concentration having been generated in the another gas-liquid separation device to the closed chamber for surface treatment of the wafer inside the chamber, and the mixed fluids containing ozone in the higher concentration are continuously utilized for surface treatment of the semiconductor wafer, so as to save the process time and meet the process requirements.

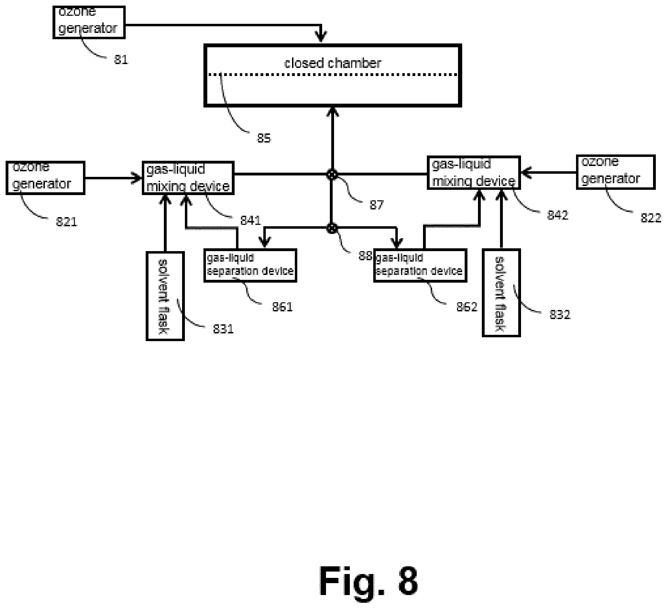

By the same token, while transferring the above-mentioned mixed fluids into the closed chamber, improving the gas phase partial pressure of ozone inside the chamber and reducing the ozone in the solutions inside the chamber transferred from the gas-liquid mixing device escaping from the fluids by adding another ozone generator and directly delivering the generated ozone to the chamber. Fig. 8 illustrates a structure diagram of the apparatus in the eighth example of the present invention. Fig. 8 comprises: an ozone generator 81, an ozone generator 821, a solvent flask 831, a gas-liquid mixing device 841, a closed chamber 85, a gas-liquid separation device 861, a switching valve 87, a switching valve 88, an ozone generator 822, a solvent flask 832, a gas-liquid mixing device 842 and a gas-liquid separation device 862. The other components of the apparatus and the method for processing a wafer are similar to the seventh example of the present invention and therefore the detailed description thereof will be omitted.

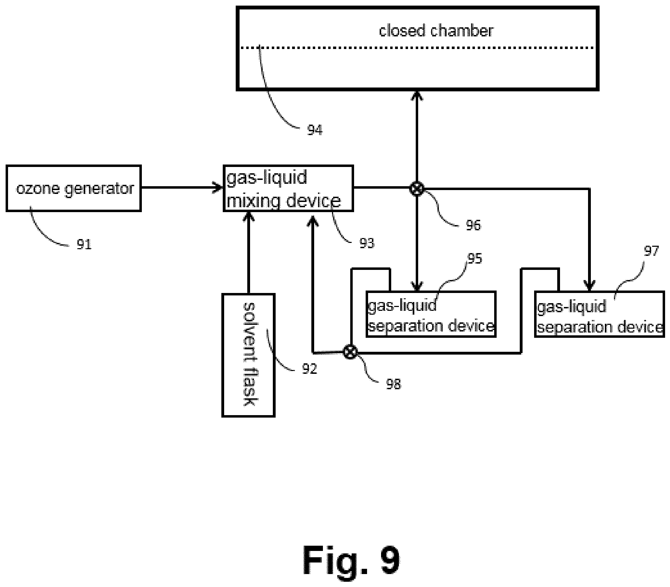

Furthermore, achieving solutions containing ozone in a higher concentration alternately prepared by adding another gas-liquid separation device, and transferring continuously the prepared solutions containing ozone into the closed chamber for surface treatment of wafer. Fig. 9 illustrates a structure diagram of the apparatus in the ninth example of the present invention. The apparatus comprises: an ozone generator 91, a solvent flask 92, a gas-liquid mixing device 93, a closed chamber 94, a gas-liquid separation device 95, a switching valve 96, a gas-liquid separation device 97, a switching valve 98, as well as a gas-liquid delivery system and a gas-liquid discharge system (not shown). The ozone generator 91 and the solvent flask 92 are connected with the corresponding inlets of the gas-liquid mixing device 93, respectively; the four outlets of the switching valve 96 are connected with the gas-liquid mixing device 93, the closed chamber 94, the gas-liquid separation device 95 and the gas-liquid separation device 97, respectively; the three outlets of the switching valve 98 are connected with the gas-liquid mixing device 93, the gas-liquid separation device 95 and the gas-liquid separation device 97, respectively. In the case that the apparatus is employed to process the semiconductor wafer, transferring the ozone gas generated by the ozone generator 91 and the solvent in the solvent flask 92 into the gas-liquid mixing device 93, respectively, for mixing the ozone gas and solvent to form mixed fluids of ozone gas and solutions containing ozone; and next transferring the mixed fluids into the gas-liquid separation device 95 by switching the switching valve 96; and transferring the mixed fluids via the gas-liquid separation into the gas-liquid mixing device 93 once again by switching the switching valve 98 so as to form mixed fluids in a higher concentration, and the ozone solutions in the higher concentration via the gas-liquid separation are transferred into the closed chamber 94 by switching the switching valve 96 until a desired concentration is reached, and a surface treatment is conducted for the wafer positioned inside the closed chamber 94. Meanwhile, continuing mixing the ozone gas and the solvent in the gas-liquid mixing device 93, transferring the formed mixed fluids into the gas-liquid separation device 97 by switching the switching valve 96; transferring the mixed fluids via the gas-liquid separation into the gas-liquid mixing device 93 once again by switching the switching valve 98 so as to form solutions containing ozone in a higher concentration following multiple circulations. Once the solutions containing ozone obtained in the gas-liquid separation device 95 are exhausted, the solutions containing ozone obtained in the gas-liquid separation device 97 are transferred into the closed chamber 95 by switching the switching valve 97 and meanwhile the mixed fluids are retrieved in the gas-liquid mixing device 93 and are circulated between the gas-liquid mixing device 93 and the gas-liquid separation device 95 so as to obtain the mixed fluids in a higher concentration and obtain solutions containing ozone in a higher concentration via the gas-liquid separation. The ozone gas released from the solutions containing ozone produced after the multiple gas-liquid mixings is retained within the closed chamber 94, so that the content of the gas phase ozone in the closed chamber 94 is higher than that of the ozone gas in the outer atmosphere, that is, increasing a partial pressure of ozone in gas phase, the ozone dissolved in the solvent is not easily escaped from the fluids, which ensures the ozone concentration in the ozone solution, thereby meeting the process requirements. It is to be remarked further that the above process consists of two gas-liquid mixing devices for obtaining solutions containing ozone in a higher concentration, which can implement that the mixed fluids containing ozone are circulated between one gas-liquid mixing device and one gas-liquid separation device so as to generate solutions containing ozone in a higher concentration; meanwhile, transferring the solutions containing ozone in the higher concentration having been generated in the another gas-liquid separation device into the closed chamber for surface treatment of the wafer inside the chamber, and the solutions containing ozone in the higher concentration are continuously utilized for surface treatment of the semiconductor wafer, so as to save the process time and meet the process requirements.

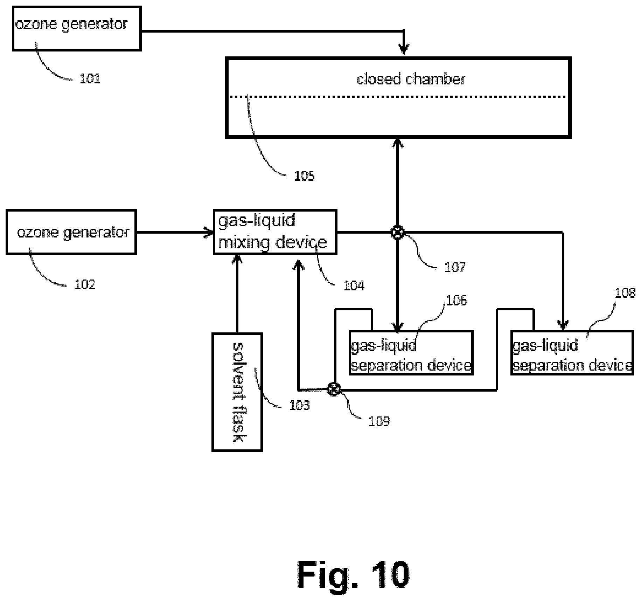

By the same token, while transferring the above-mentioned solutions containing ozone into the closed chamber, improving the gas phase partial pressure of ozone inside the chamber and reducing the ozone in the solutions inside the chamber transferred from the gas-liquid mixing device escaping from the fluids by adding another ozone generator and directly delivering the generated ozone to the chamber. Fig. 10 illustrates a structure diagram of the apparatus in the tenth example of the present invention. Fig. 10 comprises: an ozone generator 101, an ozone generator 102, a solvent flask 103, a gas-liquid mixing device 104, a closed chamber 105, a gas-liquid separation device 106, a switching valve 107, a gas-liquid separation device 108 and a switching valve 109. The other components of the apparatus and the method for processing a wafer are similar to the ninth example of the present invention and therefore the detailed description thereof will be omitted.

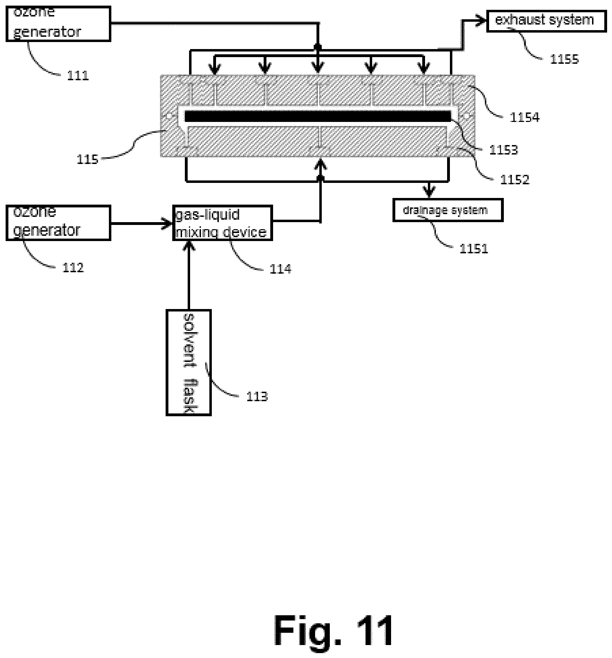

Furthermore, the closed chamber is designed as a micro processing chamber that comprises an upper chamber portion and a lower chamber portion associated with each other; the upper chamber portion and/or the lower chamber portion comprises at least one inlet configured to allow treatment fluids to be transferred into the micro processing chamber and at least one outlet configured to discharge the treatment fluids out of the micro processing chamber. Fig. 11 illustrates a structure diagram of the apparatus in an embodiment of the present invention. Fig. 11 comprises: an ozone generator 111, an ozone generator 112, a solvent flask 113, a gas-liquid mixing device 114 and a micro processing chamber 115. The micro processing chamber 115 in the apparatus comprises an upper chamber portion 1154 and a lower chamber portion 1152 associated with each other; the upper chamber portion 1154 is arranged with an exhaust system 1155 and the lower chamber portion 1152 is arranged with a drainage system 1151; a wafer 1153 is placed in the closed chamber that comprises the upper chamber portion 1154 and the lower chamber portion 1152. The other components of the apparatus and the method for processing a wafer are similar to the second example of the present invention and therefore the detailed description thereof will be omitted. The upper chamber portion and the lower chamber portion are relatively movable between an open position and a closed position. When the upper chamber portion and the lower chamber portion are in the closed position, the upper chamber portion and the lower chamber portion are enclosed to form a microcavity, the wafer can be located within the microcavity, there is a gap between the lower surface where the upper chamber portion faces the microcavity and the wafer, and a gap between the upper surface where the lower chamber portion faces microcavity and the wafer, and the height of the gap usually ranges from 0.01 mm to 10 mm. Thus the space inside the micro processing chamber is so small that the mixed fluids containing ozone transferred to the chamber can ensure the ozone concentration in the gases or liquids. When flowing outward along the wafer surface, the mixed fluids containing ozone transferred into the micro processing chamber flow through the wafer surface. The ozone and other chemical substances in the gas phase of the mixed fluids containing ozone, and the ozone and other chemical components in the liquid phase of the mixed fluids containing ozone possibly react with the wafer surface.

According to the process requirements, the solvents in the solvent flask of the present invention can use organic solutions or inorganic solutions, such as ultrapure water, hydrofluoric acid-containing solutions, acetic acids, and acetone, etc.

The gas-liquid mixing device of the present invention can use any known device, such as a jet device or a gas-liquid mixing pump.

The gas-liquid separation device of the present invention comprises a container for storing solutions containing ozone.

The ozone or the solutions containing ozone produced in the present invention can replace a plurality of conventional wafer cleaning solutions.

For example, a conventional SPM solution (No. 3 solution) consists of H₂SO₄, H₂O₂ and H₂O, and functions to remove 1) organic contaminants; and 2) a portion of metal contaminants; the problem thereof is if organic contaminations are particularly serious, after SPM cleaning, sulfides that are very difficult to wash off with water may remain on the silicon wafer surface. In the present invention, the solution in the solvent flask is indicative of a H₂O₂aqueous solution, mixed fluids containing ozone and H₂O₂ are obtained using the liquid-gas mixing device and can replace the No. 3 solution and remove organic matters using the oxidation of ozone. The absence of sulfuric acid substances prevents the residual on the wafer surface from generating sulfuric acid matters which are difficult to dissolve. Furthermore, only water is present in the solvent flask, obtaining the mixed fluids containing ozone using the liquid-gas mixing device, the mixed fluids replace No. 3 solution and remove organic matters using the oxidation of ozone.

As another example, a conventional APM solution (SC1, No.1 solution) consists of NH₄OH, H₂O₂ and H₂O and functions to remove 1) particles, 2) a portion of organic matters, and 3) a portion of metals; the problems thereof are 1) to increase silicon wafer surface roughness and 2) to attach metals such as Zn, Ni, Fe and other metals to the silicon wafer surface in the form of ionic or non-ionic metal hydroxide. In the present invention, the solution in a solvent flask is indicative of a NH₄OH aqueous solution, mixed fluids containing ozone and NH₄OH are obtained using the liquid-gas mixing device, and can replace No. 1 solution, more adequately removing particles, organic contaminants and metal contaminants using the oxidation of ozone and decreasing the silicon wafer surface roughness. The generation of hydroxide of Zn, Ni, Fe and other metal can be reduced or avoided by adjusting the concentration of NH₄OH.

As a further example, a conventional HPM solution (SC2, No. 2 solution) consists of HCl, H₂O₂ and H₂O, and functions to remove metal contaminants; the problem thereof is that it cannot effectively remove Al metal. In the present invention, the solution in the solvent flask is an HCI aqueous solution, mixed fluids containing ozone and HCI are obtained using the liquid-gas mixing device and can replace No. 2 solution, more adequately removing metal contaminants using the oxidation of ozone.

All in all, the ozone or solutions containing ozone produced in the present invention can replace No. 3 solution, No. 1 solution and No. 2 solution, which reduces the usage amount of H₂O₂, NH₄OH and HCI in the cleaning solution recipes, improves a cleaning effect and is economical and environmentally friendly.

The following are examples that illustrate an application of the method for forming a semiconductor substrate surface passivation layer by ozone produced in the present invention.

A method of passivating a semiconductor substrate fresh out of the furnace, comprising:
(a) placing the semiconductor substrate in a micro processing chamber;
(b) closing the chamber;
(c) transferring ozone gas into the chamber for 2-10 min;
(d) opening the chamber and removing the semiconductor substrate.

No HF treatment is implemented prior to passivation in the method and no drying is essential after the passivation, which greatly simplifies the process and time of the passivation.

The following Table 1 is an embodiment that employs the above method to passivate the semiconductor substrate fresh out of the furnace over 10 min.

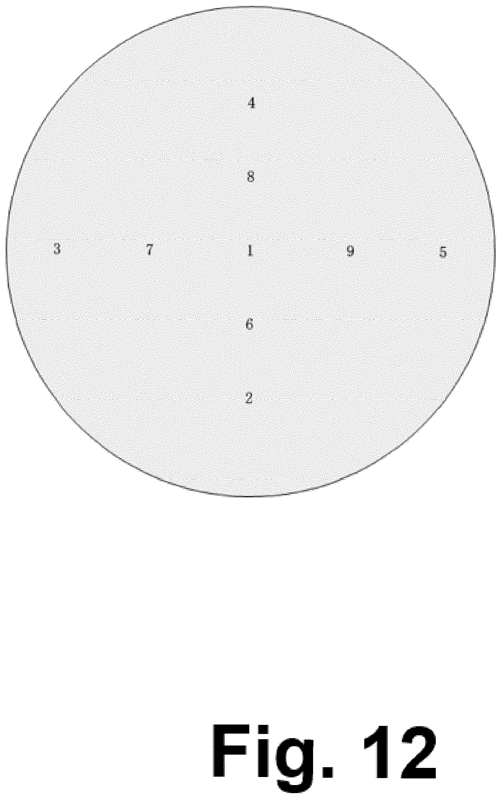

The resistivity and film thickness of the semiconductor substrate passivation layer are tested according to the position and number shown in Fig. 12.

Table 1 shows resistivity test and film thickness test data in the above example (point 9).

**Table 1**

| Testing Position | Resistivity Ω·cm | Film Thickness Å |
|---|---|---|
| 1 | 15.037 | 12.41 |
| 2 | 14.881 | 9.46 |
| 3 | 14.887 | 9.50 |
| 4 | 15.109 | 9.59 |
| 5 | 15.180 | 9.59 |
| 6 | 14.884 | 10.16 |
| 7 | 14.702 | 10.21 |
| 8 | 14.914 | 10.39 |
| 9 | 14.777 | 10.42 |

As shown in Table 1, the resistivity of the semiconductor substrate surface passivation layer is uniformly arranged and the semiconductor substrate has a better quality; except for the larger value of film thickness in the center-most air inlet, the remaining are in 9-10 Å.

The following two methods are employed to passivate the semiconductor substrate having generated a natural oxide layer.

A first method comprising:
(a) placing the semiconductor substrate in a micro processing chamber;
(b) closing the chamber;
(c) transferring the HF-containing gas or liquid into the chamber;
(d) transferring ultrapure water into the chamber;
(e) drying the chamber;
(f) transferring ozone gas into the chamber for 2-10 min;
(g) opening the chamber and removing the semiconductor substrate.

The following Table 2 is an embodiment that employs the above method to pretreat the semiconductor substrate having generated a natural oxide layer with HF fluids for 1 min and to conduct a passivation treatment for 2 min by introducing ozone gas.

The resistivity and film thickness of the semiconductor substrate passivation layer are tested according to the position and number shown in Fig. 12.

Table 2 shows resistivity test and film thickness test data in the above example (point 9).

**Table 2**

| Testing Position | Resistivity Ω·cm | Film Thickness Å |
|---|---|---|
| 1 | 14.202 | 13.8 |
| 2 | 14.04 | 13.37 |
| 3 | 14.312 | 13.46 |
| 4 | 14.14 | 13.6 |
| 5 | 14.316 | 13.3 |
| 6 | 14.014 | 13.37 |
| 7 | 14.205 | 13.58 |
| 8 | 14.112 | 13.37 |
| 9 | 14.16 | 13.3 |

As shown in Table 2, the resistivity of the semiconductor substrate surface passivation layer is uniformly arranged and the semiconductor substrate has a better quality.

A second method comprising:
(a) placing the semiconductor substrate in a micro processing chamber;
(b) closing the chamber;
(c) transferring the HF-containing gas or liquid into the chamber;
(d) transferring the ozoned water into the chamber for 2-10 min, the ozoned water is obtained by mixing ozone and water using the jet device of the gas-liquid mixing device; the gas-liquid mixing device is generally a jet device, a gas-liquid mixing pump and the like;
(e) drying the chamber;
(f) opening the chamber and removing the semiconductor substrate.

The following Table 3 is an embodiment that employs the above method to pretreat the semiconductor substrate having generated a natural oxide layer with HF fluids for 1 min and to conduct a passivation treatment for 2 min by introducing an ozone aqueous solution.

The resistivity and film thickness of the semiconductor substrate passivation layer are tested according to the position and number shown in Fig. 12.

Table 3 shows resistivity test and film thickness test data in the above example (point 9).

**Table 3**

| Testing Position | Resistivity Ω·cm | Film Thickness Å |
|---|---|---|
| 1 | 14.340 | 13.86 |
| 2 | 14.199 | 13.85 |
| 3 | 14.576 | 13.65 |
| 4 | 14.291 | 13.78 |
| 5 | 14.546 | 13.80 |
| 6 | 14.282 | 13.86 |
| 7 | 14.376 | 13.71 |
| 8 | 14.188 | 13.74 |
| 9 | 14.410 | 13.88 |

As shown in Table 3, the resistivity of the semiconductor substrate surface passivation layer is uniformly arranged and the semiconductor substrate has a better quality.

The present invention has been described in sufficient detail with a certain degree of particularity. A person skilled in the art should understand that the description in the examples is merely exemplary. The protection scope claimed in the present invention is not to be limited by the above descriptions of the examples but by the claims.

## Claims

1. An apparatus for processing a semiconductor wafer surface with fluids containing ozone, comprising:
an ozone generator (11, 21 , 22, 31, 41, 42, 51, 61, 62, 711, 712, 81, 821, 822, 91, 101, 102, 111, 112), a solvent flask (12, 23, 32, 43, 52, 63, 721, 722, 831, 832, 92, 103, 113), a gas-liquid mixing device (13, 24, 33, 44, 53, 64, 731, 732, 841, 842, 93, 104, 114), a closed chamber (14, 25, 34, 45, 54, 65, 74, 85, 94, 105, 115) for containing the wafer (1153) to be processed, and a gas-liquid delivery system and a gas-liquid discharge system; wherein the ozone generator and the solvent flask are connected with corresponding inlets of the gas-liquid mixing device, respectively, and outlets of the gas-liquid mixing device are connected with at least one inlet of the closed chamber, **characterized in that**: a gas-liquid separation device (35, 46, 55, 66, 751, 752, 861, 862, 95, 97, 106, 108) or another ozone generator (21, 41, 712, 81, 101, 111) is provided for ensuring a concentration of ozone in solution by transferring gas-liquid mixed fluids containing ozone via the gas-liquid separation device or solutions containing ozone and ozone gas after generation by the another ozone generator into the closed chamber and by increasing a partial pressure of ozone in gas phase.

2. The apparatus according to claim 1, wherein a gas-liquid separation device (35, 46, 55, 66, 751, 752, 861, 862, 95, 97, 106, 108) is disposed between the gas-liquid mixing device and the closed chamber; one outlet of the gas-liquid mixing device is connected with one inlet of the gas-liquid separation device; and at least one outlet of the gas-liquid separation device is connected with at least one inlet of the closed chamber.

3. The apparatus according to claim 2, wherein a switching valve (56, 67, 76, 77, 87, 88, 96, 98, 107, 109) is disposed between the gas-liquid mixing device, the closed chamber and the gas-liquid separation device, and three outlets of the switching valve are connected with the gas-liquid mixing device, the closed chamber and the gas-liquid separation device, respectively; and at least one outlet of the gas-liquid separation device (35) is connected with at least one inlet of the gas-liquid mixing device.

4. The apparatus according to claim 3, **characterized by** further comprising: another gas-liquid mixing device (732, 842), another ozone generator (21, 41, 712, 81, 101, 111), another solvent flask (722, 832) and another switching valve (77, 88, 98, 109); wherein the another ozone generator and the another solvent flask are connected with corresponding inlets of the another gas-liquid mixing device, respectively; four outlets of one of the switching valves are connected with the two gas-liquid mixing devices, the closed chamber and the another switching valve, respectively; the other two outlets among the three outlets of the another switching valve are connected with the two gas-liquid separation devices, respectively.

5. The apparatus according to claim 3, **characterized by** further comprising: another gas-liquid separation device (752, 862, 97, 108) and another switching valve (77, 88, 98, 109); four outlets of one of the switching valves are connected with the gas-liquid mixing device, the closed chamber and the two gas-liquid separation devices, respectively; three outlets of the another switching valve are connected with the gas-liquid mixing device and the two gas-liquid separation devices, respectively.

6. The apparatus according to claim 1, **characterized by** further comprising: another ozone generator (21, 41, 712, 81, 101, 111); wherein at least one outlet of the another ozone generator is connected with at least one inlet of the closed chamber.

7. The apparatus according to claim 1, wherein the closed chamber is in a structure of micro processing chamber that comprises an upper chamber portion (1154) and a lower chamber portion (1152) associated with each other; the upper chamber portion and/or the lower chamber portion comprises at least one inlet configured to allow treatment fluids to be transferred into the micro processing chamber and at least one outlet configured to discharge the treatment fluids out of the micro processing chamber.

8. The apparatus according to claim 6, wherein the closed chamber is in a structure of micro processing chamber that comprises an upper chamber portion (1154) and a lower chamber portion (1152) associated with each other; the upper chamber portion and/or the lower chamber portion includes at least one inlet configured to allow treatment fluids to be transferred to the micro processing chamber and at least one outlet configured to discharge the treatment fluids out of the micro processing chamber.

9. A usage method for being implemented by the apparatus according to one of claims 1 to 8, the method comprising:
transferring an ozone gas generated by the ozone generator and a solvent in the solvent flask into the gas-liquid mixing device of said apparatus, respectively;
mixing the ozone gas and the solvent to obtain mixed fluids containing the ozone gas or solutions containing ozone; and
transferring the mixed fluids or solutions into the closed chamber of said apparatus after having obtained said mixed fluids or solutions.

10. The method according to claim 9, wherein a gas-liquid separation device is disposed between the gas-liquid mixing device and the closed chamber; the mixed fluids obtained in the gas-liquid mixing device are transferred into the gas-liquid separation device, and then the solutions containing ozone are transferred into the closed chamber via the gas-liquid separation.

11. The method according to claim 10, wherein the apparatus comprises a switching valve (56, 67, 76, 77, 87, 88, 96, 98, 107, 109) disposed between the gas-liquid mixing device, the closed chamber and the gas-liquid separation device; the method comprising that the mixed fluids obtained in the gas-liquid mixing device are transferred into the gas-liquid separation device by switching the switching valve, and then transferred into the gas-liquid mixing device via the gas-liquid separation so as to obtain mixed fluids in a higher concentration, and the mixed fluids are transferred into the closed chamber through different channels by switching the switching valve until a desired concentration is reached, wherein one channel leads into the closed chamber directly, and the other channel leads into the gas-liquid separation device and then the solutions containing ozone are transferred into the closed chamber via the gas-liquid separation.

12. The method according to claim 11, **characterized in that**, the apparatus further comprises: another gas-liquid mixing device (732, 842), another ozone generator (21, 41, 712, 81, 101, 111), another solvent flask (722, 832) and another switching valve (77, 88, 98, 109); the mixed fluids in a higher concentration obtained from multiple gas-liquid mixings in one of the gas-liquid mixing devices are transferred into the closed chamber by switching one of the switching valves, and meanwhile the mixed fluids in the higher concentration are obtained from multiple gas-liquid mixings of the mixed fluids occurred in the another gas-liquid mixing device; after the mixed fluids obtained from one of the gas-liquid mixing devices are exhausted, the mixed fluids in the higher concentration having been generated in the another gas-liquid mixing device are transferred into the closed chamber by switching one of the switching valves and meanwhile multiple gas-liquid mixings of the mixed fluids occur in one of the gas-liquid mixing devices once again.

13. The method according to claim 11, **characterized in that**, the apparatus further comprises: another gas-liquid separation device (752, 862, 97, 108) and another switching valve (77, 88, 98, 109); solutions containing ozone in a higher concentration obtained in one of the gas-liquid separation devices are transferred into the closed chamber by switching one of the switching valves and meanwhile multiple gas-liquid mixings of the mixed fluids occur in the gas-liquid mixing devices and the solutions containing ozone in the higher concentration are obtained in the another gas-liquid separation device; after the solutions containing ozone obtained in one of the gas-liquid separation devices are exhausted, the solutions containing ozone in the higher concentration obtained in the another gas-liquid separation device are transferred into the closed chamber by switching one of the switching valves and meanwhile the multiple gas-liquid mixings of the mixed fluids occur in the gas-liquid mixing device once again and the solutions containing ozone in the higher concentration are obtained in one of the gas-liquid separation devices.

14. The method according to claim 9, **characterized in that**, the apparatus further comprises: another ozone generator (21, 41, 712, 81, 101, 111); the mixed fluids containing ozone or the solutions containing ozone are transferred into the closed chamber, while the ozone gas generated from the another ozone generator is transferred into the closed chamber.

## Patentansprüche

1. Vorrichtung zum Verarbeiten einer Halbleiterwaferoberfläche mit Fluiden, die Ozon enthalten, umfassend:
einen Ozongenerator (11, 21, 22, 31, 41, 42, 51, 61, 62, 711, 712, 81, 821, 822, 91, 101, 102, 111, 112), eine Lösungsmittelflasche (12, 23, 32, 43, 52, 63, 721, 722, 831, 832, 92, 103, 113), ein Gas-/Flüssigkeitsmischgerät (13, 24, 33, 44, 53, 64, 731, 732, 841, 842, 93, 104, 114), eine geschlossene Kammer (14, 25, 34, 45, 54, 65, 74, 85, 94, 105, 115) zum Enthalten des Wafers (1153), der verarbeitet werden soll, und ein Gas-/Flüssigkeitszufuhrsystem und ein Gas-/Flüssigkeitsablasssystem; wobei der Ozongenerator und die Lösungsmittelflasche jeweils mit entsprechenden Einlässen des Gas-/Flüssigkeitsmischgeräts verbunden sind und Auslässe des Gas-/Flüssigkeitsmischgeräts mit zumindest einem Einlass der geschlossenen Kammer verbunden sind, **dadurch gekennzeichnet, dass**: ein Gas-/Flüssigkeitsabscheidegerät (35, 46, 55, 66, 751, 752, 861, 862, 95, 97, 106, 108) oder ein weiterer Ozongenerator (21, 41, 712, 81, 101, 111) zum Gewährleisten einer Konzentration von Ozon in Lösung durch Überführen von Gas-/Flüssigkeitsmischfluiden, die Ozon enthalten, über das Gas-/Flüssigkeitsabscheidegerät oder von Lösungen, die Ozon und Ozongas nach der Erzeugung durch den weiteren Ozongenerator enthalten, in die geschlossene Kammer und durch Erhöhen eines Partialdrucks von Ozon in der Gasphase vorgesehen ist.

2. Vorrichtung nach Anspruch 1, wobei ein Gas-/Flüssigkeitsabscheidegerät (35, 46, 55, 66, 751, 752, 861, 862, 95, 97, 106, 108) zwischen dem Gas-/Flüssigkeitsmischgerät und der geschlossenen Kammer angeordnet ist, ein Auslass des Gas-/Flüssigkeitsmischgeräts mit einem Einlass des Gas-/Flüssigkeitsabscheidegeräts verbunden ist und zumindest ein Auslass des Gas-/Flüssigkeitsabscheidegeräts mit zumindest einem Einlass der geschlossenen Kammer verbunden ist.

3. Vorrichtung nach Anspruch 2, wobei ein Schaltventil (56, 67, 76, 77, 87, 88, 96, 98, 107, 109) zwischen dem Gas-/Flüssigkeitsmischgerät, der geschlossenen Kammer und dem Gas-/Flüssigkeitsabscheidegerät angeordnet ist und drei Auslässe des Schaltventils jeweils mit dem Gas-/Flüssigkeitsmischgerät, der geschlossenen Kammer und dem Gas-/Flüssigkeitsabscheidegerät verbunden sind und zumindest ein Auslass des Gas-/Flüssigkeitsabscheidegeräts (35) mit zumindest einem Einlass des Gas-/Flüssigkeitsmischgeräts verbunden ist.

4. Vorrichtung nach Anspruch 3, **dadurch gekennzeichnet, dass** sie ferner umfasst: ein weiteres Gas-/Flüssigkeitsmischgerät (732, 842), einen weiteren Ozongenerator (21, 41, 712, 81, 101, 111), eine weitere Lösungsmittelflasche (722, 832) und ein weiteres Schaltventil (77, 88, 98, 109); wobei der weitere Ozongenerator und die weitere Lösungsmittelflasche jeweils mit entsprechenden Einlässen des weiteren Gas-/Flüssigkeitsmischgeräts verbunden sind, vier Auslässe von einem der Schaltventile jeweils mit den zwei Gas-/Flüssigkeitsmischgeräten, der geschlossenen Kammer und dem weiteren Schaltventil verbunden sind, die zwei anderen Auslässe unter den drei Auslässen des weiteren Schaltventils jeweils mit den zwei Gas-/Flüssigkeitsabscheidegeräten verbunden sind.

5. Vorrichtung nach Anspruch 3, **dadurch gekennzeichnet, dass** sie ferner umfasst: ein weiteres Gas-/Flüssigkeitsabscheidegerät (752, 862, 97, 108) und ein weiteres Schaltventil (77, 88, 98, 109), wobei vier Auslässe von einem der Schaltventile jeweils mit dem Gas-/Flüssigkeitsmischgerät, der geschlossenen Kammer und den zwei Gas-/Flüssigkeitsabscheidegeräten verbunden sind, wobei drei Auslässe des weiteren Schaltventils jeweils mit dem Gas-/Flüssigkeitsmischgerät und den zwei Gas-/Flüssigkeitsabscheidegeräten verbunden sind.

6. Vorrichtung nach Anspruch 1, **dadurch gekennzeichnet, dass** sie umfasst: einen weiteren Ozongenerator (21, 41, 712, 81, 101, 111), wobei zumindest ein Auslass des weiteren Ozongenerators mit zumindest einem Einlass der geschlossenen Kammer verbunden ist.

7. Vorrichtung nach Anspruch 1, wobei die geschlossene Kammer in einer Mikroverarbeitungskammerstruktur vorliegt, die einen oberen Kammerabschnitt (1154) und einen unteren Kammerabschnitt (1152) umfasst, welche miteinander assoziiert sind, wobei der obere Kammerabschnitt und/oder der untere Kammerabschnitt zumindest einen Einlass, der zum Ermöglichen, dass Behandlungsfluide in die Mikroverarbeitungskammer überführt werden, konfiguriert ist, und zumindest einen Auslass umfassen, der zum Ablassen der Behandlungsfluide aus der Mikroverarbeitungskammer konfiguriert ist.

8. Vorrichtung nach Anspruch 6, wobei die geschlossene Kammer in einer Mikroverarbeitungskammerstruktur vorliegt, die einen oberen Kammerabschnitt (1154) und einen unteren Kammerabschnitt (1152) umfasst, welche miteinander assoziiert sind, wobei der obere Kammerabschnitt und/oder der untere Kammerabschnitt zumindest einen Einlass, der zum Ermöglichen, dass Behandlungsfluide zur Mikroverarbeitungskammer überführt werden, konfiguriert ist, und zumindest einen Auslass umfassen, der zum Ablassen der Behandlungsfluide aus der Mikroverarbeitungskammer konfiguriert ist.

9. Gebrauchsverfahren zur Implementierung durch die Vorrichtung nach einem der Ansprüche 1 bis 8, das Verfahren umfassend:
jeweiliges Überführen eines Ozongases, das durch den Ozongenerator erzeugt wird, und eines Lösungsmittels in der Lösungsmittelflasche in das Gas-/Flüssigkeitsmischgerät der Vorrichtung;
Mischen des Ozongases und des Lösungsmittels zum Erhalten von Mischfluiden, die das Ozongas enthalten, oder Lösungen, die Ozon enthalten; und
Überführen der Mischfluide oder Lösungen in die geschlossene Kammer der Vorrichtung nach dem Erhalten der Mischfluide oder Lösungen.

10. Verfahren nach Anspruch 9, wobei ein Gas-/Flüssigkeitsabscheidegerät zwischen dem Gas-/Flüssigkeitsmischgerät und der geschlossenen Kammer angeordnet ist, die Mischfluide, die im Gas-/Flüssigkeitsmischgerät erhalten werden, in das Gas-/Flüssigkeitsabscheidegerät überführt werden und dann die Lösungen, die Ozon enthalten, über die Gas-/Flüssigkeitsabscheidung in die geschlossene Kammer überführt werden.

11. Verfahren nach Anspruch 10, wobei die Vorrichtung ein Schaltventil (56, 67, 76, 87, 88, 96, 98, 107, 109) umfasst, das zwischen dem Gas-/Flüssigkeitsmischgerät, der geschlossenen Kammer und dem Gas-/Flüssigkeitsabscheidegerät angeordnet ist; wobei das Verfahren umfasst, dass die Mischfluide, die im Gas-/Flüssigkeitsmischgerät erhalten werden, durch Schalten des Schaltventils in das Gas-/Flüssigkeitsabscheidegerät überführt werden und dann über das Gas-/Flüssigkeitsabscheidegerät in das Gas-/Flüssigkeitsmischgerät überführt werden, um Mischfluide in einer höheren Konzentration zu erhalten, und die Mischfluide durch verschiedene Kanäle durch Schalten des Schaltventils in die geschlossene Kammer überführt werden, bis eine erwünschte Konzentration erreicht wird, wobei ein Kanal direkt in die geschlossene Kammer führt und der andere Kanal in das Gas-/Flüssigkeitsabscheidegerät führt, und dann die Lösungen, die Ozon enthalten, über die Gas-/Flüssigkeitsabscheidung in die geschlossene Kammer überführt werden.

12. Verfahren nach Anspruch 11, **dadurch gekennzeichnet, dass** die Vorrichtung ferner umfasst: ein weiteres Gas-/Flüssigkeitsmischgerät (732, 842), einen weiteren Ozongenerator (21, 41, 712, 81, 101, 111), eine weitere Lösungsmittelflasche (722, 832) und ein weiteres Schaltventil (77, 88, 98, 109), wobei die Mischfluide in einer höheren Konzentration, die aus mehrfachen Gas-/Flüssigkeitsmischungen in einem der Gas-/Flüssigkeitsgeräte erhalten werden, durch Schalten von einem der Schaltventile in die geschlossene Kammer überführt werden und währenddessen die Mischfluide in der höheren Konzentration aus mehrfachen Gas-/Flüssigkeitsmischungen der Mischfluide erhalten werden, die im weiteren Gas-/Flüssigkeitsmischgerät stattgefunden haben, wobei, nachdem die Mischfluide, die aus einem der Gas-/Flüssigkeitsmischgeräte erhalten werden, erschöpft sind, die Mischfluide in der höheren Konzentration, die im weiteren Gas-/Flüssigkeitsmischgerät erzeugt wurden, durch Schalten des Schaltventils in die geschlossene Kammer überführt werden und währenddessen mehrfache Gas-/Flüssigkeitsmischungen der Mischfluide erneut in einem der Gas-/Flüssigkeitsmischgeräte stattfinden.

13. Verfahren nach Anspruch 11, **dadurch gekennzeichnet, dass** die Vorrichtung ferner umfasst: ein weiteres Gas-/Flüssigkeitsabscheidegerät (752, 862, 97, 108) und ein weiteres Schaltventil (77, 88, 98, 109), wobei Lösungen, die Ozon in einer höheren Konzentration enthalten und in einem der Gas-/Flüssigkeitsabscheidegeräte erhalten werden, durch Schalten von einem der Schaltventile in die geschlossene Kammer überführt werden und währenddessen mehrere Gas-/Flüssigkeitsmischungen der Mischfluide in den Gas-/Flüssigkeitsmischgeräten stattfinden und die Lösungen, die Ozon in der höheren Konzentration enthalten, in dem weiteren Gas-/Flüssigkeitsabscheidegerät erhalten werden, wobei, nachdem die Lösungen, die Ozon enthalten und in einem der Gas-/Flüssigkeitsabscheidegeräte erhalten werden, erschöpft sind, die Lösungen, die Ozon in der höheren Konzentration enthalten und in dem weiteren Gas-/Flüssigkeitsabscheidegerät erhalten werden, durch Schalten von einem der Schaltventile in die geschlossene Kammer überführt werden und währenddessen die mehrfachen Gas-/Flüssigkeitsmischungen der Mischfluide im Gas-/Flüssigkeitsmischgerät erneut stattfinden und die Lösungen, die Ozon in der höheren Konzentration enthalten, in einem der Gas-/Flüssigkeitsabscheidegeräte erhalten werden.

14. Verfahren nach Anspruch 9, **dadurch gekennzeichnet, dass** die Vorrichtung ferner umfasst: einen weiteren Ozongenerator (21, 41, 712, 81, 101, 111), wobei die Mischfluide, die Ozon enthalten, oder die Lösungen, die Ozon enthalten, in die geschlossene Kammer überführt werden, während das Ozongas, das durch den weiteren Ozongenerator erzeugt wird, in die geschlossene Kammer überführt wird.

## Revendications

1. Dispositif de traitement d'une surface de plaquette de semi-conducteurs avec des fluides contenant de l'ozone, comprenant :
un générateur d'ozone (11, 21, 22, 31, 41, 42, 51, 61, 62, 711, 712, 81, 821, 822, 91, 101, 102, 111, 112), une flasque de solvant (12, 23, 32, 43, 52, 63, 721, 722, 831, 832, 92, 103, 113), un dispositif de mélange gaz-liquide (13, 24, 33, 44, 53, 64, 731, 732, 831, 842, 93, 104, 114), une chambre fermée (14, 25, 34, 45, 54, 65, 74, 85, 94, 105, 115) pour contenir la plaquette (1153) à traiter et un système de remise de gaz-liquide et un système d'évacuation de gaz-liquide ; dans lequel le générateur d'ozone et la flasque de solvant sont raccordés avec les entrées correspondantes du dispositif de mélange de gaz-liquide, respectivement, et les sorties du dispositif de mélange de gaz-liquide sont raccordées à au moins une entrée de la chambre fermée, **caractérisé en ce que** : un dispositif de séparation de gaz-liquide (35, 46, 55, 66, 751, 752, 861, 862, 95, 97, 106, 108) ou un autre générateur d'ozone (21, 41, 712, 81, 101, 111) est prévu pour garantir une concentration d'ozone en solution en transférant les fluides mélangés gaz-liquide contenant de l'ozone via le dispositif de séparation de gaz-liquide ou des solutions contenant de l'ozone et du gaz d'ozone après la génération par un autre générateur d'ozone dans la chambre fermée et en augmentant une pression partielle d'ozone en phase gazeuse.

2. Dispositif selon la revendication 1, dans lequel un dispositif de séparation de gaz-liquide (35, 46, 55, 66, 751, 752, 861, 862, 95, 97, 106, 108) est disposé entre le dispositif de de gaz-liquide et la chambre fermée ; une sortie du dispositif de mélange de gaz-liquide est raccordée à une entrée du dispositif de séparation de gaz-liquide ; et au moins une sortie du dispositif de séparation de gaz-liquide est raccordée à au moins une entrée de la chambre fermée.

3. Dispositif selon la revendication 2, dans lequel une soupape de commutation (56, 67, 76, 77, 87, 88, 96, 98, 107, 109) est disposée entre le dispositif de mélange de gaz-liquide, la chambre fermée et le dispositif de séparation de gaz-liquide, et trois sorties de la soupape de commutation sont raccordées avec le dispositif de mélange de gaz-liquide, la chambre fermée et le dispositif de séparation de gaz-liquide, respectivement ; et au moins une sortie du dispositif de séparation de gaz-liquide (35) est raccordée à au moins une entrée du dispositif de mélange de gaz-liquide.

4. Dispositif selon la revendication 3, **caractérisé en ce qu'**il comprend en outre : un autre dispositif de mélange de gaz-liquide (732, 842), un autre générateur d'ozone (21, 41, 712, 81, 101, 111), une autre flasque de solvant (722, 832) et une autre soupape de commutation (77, 88, 98, 109) ; dans lequel l'autre générateur d'ozone et l'autre flasque de solvant sont raccordés avec des entrées correspondantes d'un autre dispositif de mélange de gaz-liquide, respectivement ; quatre sorties d'une des soupapes de commutation sont raccordées avec les deux dispositif de mélange de gaz-liquide, la chambre fermée et une autre soupape de commutation, respectivement ; les autres sortie parmi les trois sorties d'une autre soupape de commutation sont raccordés avec les deux dispositifs de réparation de gaz-liquide, respectivement.

5. Dispositif selon la revendication 3, **caractérisé en ce qu'**il comprend en outre : un autre dispositif de séparation de gaz-liquide (752, 862, 97, 108) et une autre soupape de commutation (77, 88, 98, 109) ; quatre sorties d'une des soupapes de commutation sont raccordées avec le dispositif de mélange de gaz-liquide, la chambre fermée et les deux dispositifs de séparation de gaz-liquide, respectivement ; trois sorties d'une autre soupape de commutation sont raccordées avec le dispositif de mélange de gaz-liquide et les deux dispositifs de séparation de gaz-liquide, respectivement.

6. Dispositif selon la revendication 1, **caractérisé en ce qu'**il comprend en outre : un autre générateur d'ozone (21, 41, 712, 81, 101, 111) ; dans lequel au moins une sortie d'un autre générateur de zone est raccordée à au moins une entrée de la chambre fermée.

7. Dispositif selon la revendication 1, dans lequel la chambre fermée est dans une structure de chambre de micro traitement qui comprend une portion de chambre supérieure (1154) et une portion de chambre intérieure (1152) associées l'une à l'autre ; la portion de chambre supérieure et/ou la portion de chambre inférieure comprend au moins une entrée configurée pour permettre à des fluides de traitement d'être transférés à l'intérieur de la chambre de micro traitement et au moins une sortie configurée pour évacuer les fluides de traitement hors de la chambre de micro traitement.

8. Dispositif selon la revendication 6, dans lequel la chambre fermée est dans une structure de chambre de micro traitement qui comprend une portion de chambre supérieure (1154) et une portion de chambre intérieure (1152) associées l'une à l'autre ; la portion de chambre supérieure et/ou la portion de chambre inférieure inclut au moins une entrée configurée pour permettre à des fluides de traitement d'être transférés vers la chambre de micro traitement et au moins une sortie configurée pour évacuer les fluides de traitement hors de la chambre de micro traitement.

9. Procédé d'utilisation étant implémenté par le dispositif selon une des revendications 1 à 8, le procédé comprenant de :
transférer un gaz d'ozone généré par le générateur d'ozone et un solvant dans la flasque de solvant à l'intérieur du dispositif de mélange de gaz-liquide dudit dispositif, respectivement ;
mélangez le gaz d'ozone et le solvant pour obtenir des fluides mélangés contenant le gaz d'ozone ou des solutions contenant de l'ozone; et
transférer les fluides ou les solutions mélangés à l'intérieur de la chambre fermée dudit dispositif après avoir obtenu lesdits fluide ou solutions mélangés.

10. Procédé selon la revendication 9, dans lequel un dispositif de séparation de gaz-liquide est disposé entre le dispositif de mélange de gaz-liquide et la chambre fermée ; les fluides mélangés obtenus dans le dispositif de mélange de gaz-liquide sont transférés à l'intérieur du dispositif de séparation de gaz-liquide et ensuite les solutions contenant de l'ozone sont transférées à l'intérieur de la chambre fermée via la séparation de gaz-liquide.

11. Procédé selon la revendication 10, dans lequel le dispositif comprend une soupape de commutation (56, 67, 76, 77, 87, 88, 96, 98, 107, 109) disposée entre le dispositif de mélange de gaz-liquide, la chambre fermée et le dispositif de séparation de gaz-liquide ; le procédé comprenant que les fluides mélangés obtenus dans le dispositif de mélange de gaz-liquide sont transférés à l'intérieur du dispositif de séparation de gaz-liquide en commutant la soupape de commutation, et ensuite transférés à l'intérieur du dispositif de mélange de gaz-liquide via la séparation de gaz-liquide de manière à obtenir des fluides mélangés dans une concentration plus élevée, et les fluides mélangés sont transférés à l'intérieur de la chambre fermée par l'intermédiaire de canaux différents en commutant la soupape de commutation jusqu'à ce qu'une concentration désirée soit atteinte, dans lequel un canal mène à l'intérieur de la chambre fermée directement, et l'autre canal mène à l'intérieur du dispositif de séparation de gaz-liquide et ensuite les solutions contenant de l'ozone sont transférées à l'intérieur de la chambre fermée via la séparation de gaz-liquide.

12. Procédé selon la revendication 11, **caractérisé en ce que** le dispositif comprend en outre : un autre dispositif de mélange de gaz-liquide (732, 842), un autre générateur d'ozone (21, 41, 712, 81, 101, 111), une autre flasque de solvant (722, 832) et une autre soupape de commutation (77, 88, 98, 109) ; les fluides mélangés dans une concentration plus élevée obtenus à partir de mélanges multiples de gaz-liquide dans un des dispositifs de mélange de gaz-liquide sont transférés à l'intérieur de la chambre fermée en commutant une des soupapes de commutation, et entre-temps les fluides mélangés dans la concentration plus élevée sont obtenus à partir de mélange de gaz-liquide multiples survenus dans un autre dispositif de mélange de gaz-liquide ; après que les fluides mélangés obtenus à partir d'un des dispositifs de mélange de gaz-liquide sont épuisés, les fluides mélangés dans la concentration plus élevée ayant été générés dans un autre dispositif de mélange de gaz-liquide sont transféré à l'intérieur de la chambre fermée en commutant une des soupapes de commutation et entre-temps des mélanges multiples de gaz-liquide des fluides mélangés se produisent dans un des dispositifs de mélange de gaz-liquide une fois de plus.

13. Procédé selon la revendication 11, **caractérisé en ce que** le dispositif comprend en outre : un autre dispositif de séparation de gaz-liquide (752, 862, 97, 108) et une autre soupape de commutation (77, 88, 98, 109) ; des solutions contenant de l'ozone dans une concentration plus élevée obtenue dans un des dispositifs de séparation de gaz-liquide sont transférés à l'intérieur de la chambre fermée en commutant une des soupapes de commutation et entre-temps des mélanges multiples de gaz-liquide des fluides mélangés se produisent dans les dispositifs de mélange de gaz-liquide et les solutions contenant de l'ozone dans la concentration plus élevée sont obtenues dans un autre dispositif de séparation de Gaz-liquide ; après que les solutions contenant de l'ozone obtenues dans un des dispositifs de séparation de Gaz-liquide sont épuisées, les solutions contenant de l'ozone dans la concentration plus élevée obtenue dans un autre dispositif de séparation de gaz-liquide sont transférées à l'intérieur de la chambre fermée en commutant une des soupapes de commutation et entre-temps les mélanges multiples de gaz-liquide des fluides mélangés se produisent dans le dispositif de mélange de gaz-liquide une fois de plus et les solutions contenant de l'ozone dans la concentration plus élevée sont obtenues dans un des dispositifs de séparation de gaz-liquide.

14. Procédé selon la revendication 9, caractérisé ce que le dispositif comprend en outre : un autre générateur d'ozone (21, 41, 712, 81, 101, 111) ; les fluides mélangés contenant de l'ozone ou les solutions contenant de l'ozone sont transférées à l'intérieur de la chambre fermée, alors que le gaz d'ozone généré à partir d'un autre générateur d'ozone est transféré à l'intérieur de la chambre fermée.
